# EUROPÄISCHE PATENTSCHRIFT

(11) **EP 1 419 530 B1**
(45) Veröffentlichungstag und Bekanntmachung des Hinweises auf die Patenterteilung: **08.08.2007**
(21) Anmeldenummer: 02779276.1
(22) Anmeldetag: 26.08.2002
(51) Int. Cl.: H01L 25/16, H01L 31/0232

(54) **VERFAHREN ZUR HERSTELLUNG VON ELEKTRONISCHEN BAUELEMENTEN**
METHOD FOR PRODUCING ELECTRONIC COMPONENTS
PROCEDE DE PRODUCTION DE COMPOSANTS ELECTRONIQUES

(30) Priorität: 24.08.2001 DE 10141571; 24.08.2001 DE 10141558; 23.05.2002 DE 10222960
(43) Veröffentlichungstag der Anmeldung: 19.05.2004
(73) Patentinhaber: Schott AG, 55122 Mainz (DE)
(72) Erfinder: LEIB, Jürgen, 85345 Freising (DE); BIECK, Florian, 01199 Drsden (DE)
(74) Vertreter: Herden, Andreas F.
(86) Internationale Anmeldenummer: PCT/EP2002/009497
(87) Internationale Veröffentlichungsnummer: WO 2003/019617

(56) Entgegenhaltungen:
- EP-A- 0 550 973
- WO-A-99/18612
- US-A- 5 500 540
- US-A- 5 761 350
- US-A- 5 915 168
- US-B1- 6 328 482
- PFEIFFER J ET AL: "Tunable wavelength-selective WDM photodetector based on MOEMS" ANNUAL REPORT TECHNICAL UNIVERSITY DARMSTADT, XX, XX, 1999, Seiten 94-98, XP002195782
- JIM K L ET AL: "Fabrication of wafer level chip scale packaging for optoelectronic devices" 1999 PROCEEDINGS. 49TH ELECTRONIC COMPONENTS AND TECHNOLOGY CONFERENCE (CAT. NO.99CH36299), 1999 PROCEEDINGS. 49TH ELECTRONIC COMPONENTS AND TECHNOLOGY CONFERENCE, SAN DIEGO, CA, USA, 1-4 JUNE 1999, Seiten 1145-1147, XP002248941 1999, Piscataway, NJ, USA, IEEE, USA ISBN: 0-7803-5231-9
- LECLERCQ J-L ET AL: "INP-BASED MOEMS AND RELATED TOPICS" JOURNAL OF MICROMECHANICS & MICROENGINEERING, NEW YORK, NY, US, Bd. 10, Nr. 2, 27. September 1999 (1999-09-27), Seiten 287-292, XP008002312 ISSN: 0960-1317

## Beschreibung

Die Erfindung betrifft ein Verfahren zur Herstellung von elektronischen Bauelementen, sowie ein gehäustes elektronisches Bauelement. Insbesondere betrifft die Erfindung ein Verfahren zur Herstellung gehäuster elektronischer Bauelemente im Waferverband mit einer strukturierten Auflage, sowie ein gehäustes elektronisches Bauelement mit einer strukturierten Auflage.

Für die Herstellung von integrierten elektronischen Bauelementen werden heute unter anderem verschiedene Wafer-Level-Packaging-Verfahren angewendet. Unter anderem wird dieses Verfahren auch zur Herstellung opto-elektronischer Bauelemente verwendet. Dazu werden die Bauelemente mit lichtdurchlässigen Abdeckungen versehen, welche die lichtempfindlichen Bauelemente vor Umgebungseinflüssen, wie beispielsweise Feuchtigkeit oder etwa vor mechanischen Beschädigungen schützen.

Jedoch werden dabei bisher mechanische und optische Funktionen unabhängig von der eigentlichen Gehäusung des Halbleiters bei einer späteren Montage realisiert. So werden beispielsweise Optiken, wie Kunststoff-Objektive oder Glasfasern nach Herstellung des gehäusten optischen Chips mit diesem verbunden. Zwangsläufig führt dies jedoch zu großen Fertigungstoleranzen im Vergleich mit der sonst bei der Herstellung integrierter Schaltkreise hohen erreichbaren Genauigkeit. Zudem müssen die fertig gehäusten Bauelemente nach dem Dicen, also dem Abtrennen der Chips oder Dies vom Wafer neu einjustiert und ausgerichtet werden, bevor die optischen Elemente aufgesetzt werden, was zu zusätzlichen Fertigungsschritten führt und entsprechend die Produktion verlangsamt und verteuert.

Ferner sind auch sogenannte Batch-Verfahren oder Verfahren, welche auf Wafer-Ebene arbeiten bekannt. In dem US-Patent 6,328,482 ist z.B. ein Multilayer-Koppler zum Koppeln optischer Strahlung zwischen einer optischen Einrichtung und der optischen Faser beschrieben. Zur Herstellung der Koppler werden ein Silizium-Wafer mit photolithographisch geätzten Faseraufnahmehülsen und ein Glaswafer mit Mikrolinsen gebondet und nachfolgend zerteilt. Mit diesem Verfahren kann zum Beispiel eine Vielzahl von VCSELs (Vertical Cavity Surface Emitting Lasers) parallel auf dem Wafer hergestellt werden, wobei die VCSELs lateral an der Unterseite des Silizium-Wafers kontaktiert werden.

In dem US-Patent 5,915,168 ist ein Verfahren zum hermetischen Gehäusen von integrierten Schaltungen auf Waferebene beschrieben, bei welchem ein schützender Deckwafer auf einen Halbleiterelementsubstratwafer gebondet wird. Hierzu werden zunächst der Quarz- oder Glasdeckwafer mit dem Device-Wafer verbunden, wobei der Deckwafer an seiner Unterseite mehrere Kavitäten aufweist. Durch teilweise Entfernung des Deckwafers, zum Beispiel mittels Ätzen oder Läppen und nachfolgendes Trennen der Dies entstehen die vereinzelten Bauelemente.

Ferner ist in dem US-Patent 5,761,350 ein Verfahren zum Herstellen einer fugenlosen optischen Multilayeranordnung beschrieben. Diese Anordnung umfasst ein Spiegelsubstrat, eine Mehrzahl von optischen Wellenleitern und eine photonische Einrichtung. Die photonische Einrichtung enthält eine Mehrzahl von Photodetektoren, welche Licht, das zeitlich über die optischen Wellenleiter eingekoppelt und über dreiecksförmige Spiegel reflektiert wird, detektiert. Die Kontaktierung erfolgt auf derjenigen Seite, auf welcher die Verarmungszonen angeordnet sind. Auf dieser Seite sind Bonding Pads angebracht, welche über Lotmittelkügelchen mit paarenden Bonding Pads elektrisch verbunden sind.

Die in den vorstehend genannten Dokumenten beschriebenen Verfahren sind jedoch, insbesondere in Bezug auf die Kontaktierung unflexibel und weiter verbesserungswürdig.

Die Erfindung hat es sich daher zur Aufgabe gemacht, diese Nachteile bei der Herstellung und dem Aufbau elektronischer Bauelemente, wie insbesondere opto-elektronische Bauteile zu vermeiden oder zumindest zu mildern.

Diese Aufgabe wird bereits in überraschend einfacher Weise durch ein Verfahren gemäß Anspruch 1, sowie ein elektronisches Bauelement gemäß Anspruch 30 gelöst. Vorteilhafte Weiterbildungen sind Gegenstand der jeweiligen Unteransprüche.

Dementsprechend umfaßt das erfindungsgemäße Verfahren zur Herstellung eines elektronischen Bauelements, welches wenigstens ein Halbleiterelement umfasst, das auf zumindest einer Seite zumindest eine sensorisch aktive und/oder emittierende Einrichtung aufweist, die Schritte:
- Bereitstellen zumindest eines Dies auf einem Wafer,
- Herstellen zumindest einer strukturierten Auflage, welche zumindest eine für die sensorisch aktive und/oder emittierende Einrichtung funktionelle Struktur aufweist,
- Zusammenfügen des Wafers mit der zumindest einen Auflage, so daß die Seite des Dies, welche die sensorisch aktive und/oder emittierende Einrichtung aufweist, der Auflage zugewandt ist, und
- Abtrennen des Dies.

Unter einem elektronischen Bauelement wird in diesem Zusammenhang ein Bauelement verstanden, welches elektrische Signale in andere Signale, und/oder andere Signale in elektrische Signale wandeln kann. Insbesondere sind hierunter opto-elektronische Bauelemente zu verstehen, welche optische in elektrische Signale und umgekehrt wandeln können. Ebenso fallen unter den Begriff eines elektronischen Bauelements jedoch auch andere sensorische und/oder emittierende Elemente, die beispielsweise physikalische Meßgrößen wie Schall oder Druck oder chemische Meßgrößen wie beispielsweise Konzentrationen, in elektrische Signale oder zurück wandeln können.

Bei dem erfindungsgemäßen Verfahren werden die Bauelemente mit der mit für die sensorisch aktive und/oder emittierende Einrichtung funktionellen Strukturen versehenen Auflage bereits im Waferverbund zusammengefügt. Dies ermöglicht eine exakte Ausrichtung der Strukturen der Auflage zu der sensorisch aktiven und/oder emittierenden Einrichtung, wie beispielsweise einer photoelektrischen Sensorschicht. Weiterhin wird durch das erfindungsgemäße Verfahren auch das Wafer-Level-Packaging durch das Aufbringen der strukturierten Auflage zumindest teilweise mit dem Anbringen weiterer funktioneller Strukturen oder Elemente, wie beispielsweise optische Linsen für opto-elektronische Bauelemente integriert. Dies spart bei der Herstellung solcher sensorisch aktiver und/oder emittierender Bauelemente weitere Prozeßschritte. Zudem lassen sich die Abmessungen des Bauelements durch die größere Nähe der funktionellen Strukturen der Auflage zu den Sensoren oder emittierenden Strukturen auf dem Chip erheblich kleiner gestalten, was einen bedeutenden Beitrag zur Miniaturisierung von derartigen elektronischen Bauelementen liefert.

In besonders vorteilhafter Weise kann das erfindungsgemäße Verfahren auch die Herstellung einer mehrlagigen strukturierten Auflage umfassen. Diese Lagen können dabei auch verschiedene Materialien aufweisen. So können beispielsweise transparente Lagen aus Glas oder Kunststoff mit Halbleiterschichten kombiniert werden.

Insbesondere ist vorteilhaft, wenn die einzelnen Lagen jeweils zumindest eine für die sensorisch aktive und/oder emittierende Einrichtung funktionelle Struktur aufweisen. Beispielsweise können auf diese Weise mehrelementige Optiken für opto-elektronische Bauelemente zusammengesetzt werden.

Die Strukturierung kann im mit dem Wafer zusammengefügen Zustand erfolgen. Beispielsweise können Polymer-Reflow-Linsen auf der Auflage aufgebracht werden. Die Strukturierung im zusammengefügten Zustand ist unter anderem auch dann vorteilhaft, wenn die Auflage so dünn ist, daß der Vorgang des Strukturierens, etwa durch mechanische Bearbeitung die Auflage zerstören würde. Durch das Zusammenfügen mit dem Wafer wird die Auflage unterstützt und dem Aufbau so eine erhöhte Festigkeit verliehen, was die zerstörungsfreie Bearbeitung der Auflage ermöglicht.

Vorteilhaft ist auch ein Vorfertigen von Strukturen auf der Auflage vor dem Zusammenfügen. Die Auflage mit den vorgefertigten Strukturen läßt sich dann beispielsweise beim Zusammenfügen mit dem Wafer zu diesem exakt ausrichten. Die Vorfertigung der Strukturen und das nachfolgende Verbinden mit dem Wafer erlaubt es Materialien auf dem Halbleiter zu verwenden, welche die Vorprozesse des Strukturierens der Auflage nicht überstehen würden. Beispielsweise wird so der Einsatz biosensorischer Rezeptoren oder organischer Mikrolinsen auf dem Halbleiterelement ermöglicht.

Die einzelnen Lagen der mehrlagigen strukturierten Auflage müssen nicht erst miteinander verbunden werden, bevor dieser Verbund mit dem Wafer zusammengefügt wird. Vielmehr ist es auch von Vorteil, wenn das Zusammenfügen mit der Auflage so durchgeführt wird, daß einzelne Lagen an den Wafer, beziehungsweise dem Verbund aus Wafer und den schon mit diesem zusammengefügten Lagen angefügt werden. Beispielsweise kann dann jede Lage separat auf die Strukturen des Wafers ausgerichtet werden. Auch ist auf diese Weise eine Strukturierung der auf dem Wafer befestigten Lagen oder beispielsweise ein mechanisches Ausdünnen der Lagen im Waferverbund möglich.

Die Herstellung der Auflage kann beispielsweise mittels lithographischer Strukturierung durchgeführt werden. Dies kann durch Einsatz geeigneter Schattenmasken oder auch durch Abformung von einer lithographisch hergestellten Vorform (LIGA-Verfahren) vorgenommen werden.

Zur Erzeugung geeigneter funktioneller Strukturen der Auflage kann diese sowohl negativ als auch positiv strukturiert werden.

Dabei wird die negative Strukturierung bevorzugt durch Trockenätzen und/oder nasschemischem Ätzen und/oder mechanisches Schleifen, beziehungsweise Grinding und/oder mechanisches Läppen erzeugt. Positive Strukturen lassen sich unter anderem mittels Bedampfung, Aufsputtern von Material, CVD- oder PVD-Beschichtungen, Plating oder Stencil Printing und Belackung herstellen.

Für miniaturisierte Optiken sind unter anderem strukturierte Auflagen interessant, welche Abstandhalter für optische Elemente aufweisen. Durch die hohe erzielbare Genauigkeit beim Positionieren der Auflage und die hohe Parallelität von Waferoberfläche und Auflage welche durch das Zusammenfügen im Waferverbund erreicht wird, lassen sich auch auf Miniaturmaßstab beispielsweise bei opto-elektronischen Bauelementen Präzisionsoptiken für die sensorisch aktiven und/oder emittierenden Einrichtungen der Dies auf dem Wafer, die nach dem Abtrennen, beziehungsweise Dicen des Wafers die Halbleiterelemente der elektronischen Bauelemente bilden, aufbauen.

Außerdem lassen sich in der Auflage Aufnahmen herstellen, die beispielsweise Fluide, etwa für Sensoranwendungen in der Fluidik oder für chemische Sensoren, optische Elemente, mikroelektronische Komponenten oder aktive oder passive elektronische Elemente aufnehmen kann. Die Aufnahmen können auch separate Sensor- oder Emitterkomponenten, beispielsweise piezoelektrische Drucksensoren oder piezoelektrische Emitter, wie etwa Ultraschallemitter passgenau aufnehmen.

Als weitere funktionelle Strukturen kommen auch Hohlräume in Betracht. Insbesondere kann die strukturierte Auflage dabei so hergestellt werden, daß im Bauteil zumindest ein Resonatorraum definiert wird. Diese in der Auflage oder zwischen Auflage und Halbleiterelement definierten Hohlräume können dabei auch wenigstens teilweise offen sein. Ein Hohlraum kann auch mit Vorteil die Oberfläche der sensorisch aktiven und/oder emittierende Einrichtung oder auf dieser angeordnete optische Elemente umgeben und diese so beispielsweise vor Beschädigungen schützen.

Für viele Anwendungen sind auch mechanische Passungen als Strukturen der Auflage besonders vorteilhaft. Beispielsweise kann in der Auflage eine Passung für einen Wellenleiter erzeugt werden. Auch hier kann wieder die hohe erzielbare Genauigkeit bei der Ausrichtung der Auflage mit dem Wafer im Waferverbund vorteilhaft dazu ausgenutzt werden, um den Wellenleiterkern in präzise Ausrichtung mit einer Sensor- oder Emitterstruktur auf dem Die oder Chip zu bringen. Ebenso kann eine mechanische Passung auch zur Ausrichtung anderer funktioneller Elemente, wie etwa Linsen oder weiterer Auflagen dienen. Diese können auch in späteren Fertigungsprozessen, etwa nach dem Dicen des Wafers montiert werden. Selbst bei nachträglicher Montage weiterer Elemente überträgt sich die erreichbare Präzision bei der Zusammensetzung von Auflage und Wafer im Waferverbund und die damit erreichte Genauigkeit der Ausrichtung der Passung auf die weiteren Elemente.

Überdies kann die Auflage so strukturiert werden, daß sie selbst optische Komponenten wie etwa Linsen oder Gitter als funktionelle Strukturen umfaßt. Die Auflage kann vorteilhaft ferner so hergestellt werden, daß sie zumindest einen Durchgang als funktionelle Struktur aufweist. Derartige Durchgänge können insbesondere die Aufgabe erfüllen, eine Verbindung mit der sensorisch aktiven und/oder emittierenden Einrichtung, beziehungsweise Sensor- oder Emitterstruktur zu anderen funktionellen Strukturen oder zur Umgebung des Bauelements herzustellen.

Als optische Komponenten, die während des Herstellens der Auflage in diese integriert werden können, kommen unter anderem allgemein konkave und/oder konvexe Linsen, Fresnel-Linsen oder Prismenlinsen, Gitter, insbesondere Phasengitter und/oder Prismen in Betracht. Prismen können beispielsweise in Kombination mit Führungen oder Passungen für Wellenleiter kombiniert werden, um das Licht von entlang der Oberfläche des Bauelements geführten Welenleitern auf die sensorisch aktive und/oder emittierende Einrichtung umzulenken.

Schließlich sind als funktionelle Strukturen auch Gräben, insbesondere V-Nuten für bestimmte Anwendungen geeignet. Ein Graben oder eine V-Nut erstreckt sich dabei auf der Auflage vorzugsweise in einer Richtung entlang der Oberfläche der Auflage. Solche Nuten oder Gräben können unter anderem zur Aufnahme und Fixierung von Wellenleitern verwendet werden. Beispielsweise ergibt sich so, wie oben beschrieben, eine vorteilhafte Kombination von V-Grooves als Führungen für Wellenleiter in Verbindung mit Prismen als Lichtumlenkelemente.

Das erfindungsgemäße Verfahren läßt sich auch mit Vorteil so erweitern, daß das Zusammenfügen des Wafers mit der zumindest einen strukturierten Auflage außerdem den Schritt des Zusammenfügens mit zumindest einer weiteren, als Abstandhalter wirkenden Auflage umfaßt. Auf diese Weise lassen sich ein oder mehrere als Abstandhalter wirkende strukturierte Auflagen miteinander und/oder mit einer Auflage kombinieren, die weitere funktionelle Strukturen, wie Linsen, mechanische Passungen oder ähnliches aufweisen.

Unter anderem kann die Auflage vorteilhaft aus einem Halbleitermaterial, insbesondere Silizium oder Galliumarsenid hergestellt werden. Auch Indiumphosphid, welches sonst hermetisch abgeschlossen sein muß, kann als Auflagematerial verwendet werden, wobei die hermetische Abdichtung beispielsweise durch weitere Lagen der Auflage schon im Waferverbund erzielt werden kann. Die oben genannten Halbleitermaterialien lassen sich mit bekannten Verfahren präzise bearbeiten, um die jeweiligen funktionellen Strukturen zu erzeugen. Auch Glas, insbesondere Quarzglas und/oder Metall als Material für die Auflagen kann abhängig von dem beabsichtigten Einsatzgebiet des Bauelements mit Vorteil verwendet werden. Interessante Eigenschaften können unter anderem auch mit Glasschäumen oder Metallschäumen erzielt werden.

Allgemein können auch Low-k-Dielektrika vorteilhaft verwendet werden, beispielsweise um parasitäre Kapazitäten auf den Bauelementen zu verringern und so die Hochfrequenzeigenschaften der Bauelemente zu verbessern. Als Low-k-Materialien können unter anderem verschiedene Kunststoffe oder geschäumte Materialien, wie geschäumte Gläser verwendet werden. Dies ist insbesondere auch dann von Vorteil, wenn das Halbleiterbauelement ein Hochfrequenz-Bauteil umfaßt.

Auch Saphir als Auflagematerial besitzt beispielsweise aufgrund seiner hohen Temperaturleitfähigkeit und UV-Durchlässigkeit für einige Anwendungen hervorragende Eigenschaften.

Weiterhin können auch Verbundwerkstoffe, Keramiken oder Kunststoffe oder viele andere anorganische und organische Materialien je nach Anwendungsbereich und Zweck mit Vorteil als Auflagematerial verwendet werden.

Insbesondere können Auflage und Wafer ein gleiches Material umfassen. Dies bietet unter anderem die Möglichkeit, kostensparend den Wafer mit den Dies und die Auflage mit den gleichen Verfahren zu bearbeiten.

Wafer und Auflage können weiterhin so hergestellt werden, daß sie an den einander zugewandten Grenzflächen aufeinander angepaßte Temperaturausdehnungskoeffizienten aufweisen. Damit lassen sich Temperaturspannungen zwischen Wafer und Auflage vermeiden, beziehungsweise verringern. Beispielsweise sind für GaAlAs-Wafer Materialien wie Kovar und D263-Glas für die Auflage geeignet. Für Si(100)-Wafer können unter anderem die Gläser AF45, AF37 oder B33 verwendet werden.

Um Wafer und Auflage zusammenzufügen ist insbesondere das anodische Bonden des Wafers mit der Auflage geeignet. Jedoch sind auch, abhängig von den verwendeten Materialien Verklebungen, beispielsweise mit Polymeren und/oder Epoxyklebern, Verbinden mittels Legierungslöten vorher metallisierter Bereiche des Wafers und/oder der Auflage, sowie Diffusionsverschweißung oder Verbindung durch Glaslote denkbar. Umfaßt die Auflage mehr als eine Schicht, können die verschiedenen Verfahren des Zusammenfügens auch miteinander kombiniert werden. Insbesonder für Auflagen, die Glas umfassen kann auch vorteilhaft Glaslöten für das Zusammenfügen benutzt werden.

Um das Dicen des Gesamtaufbaus aus Wafer und Auflage zu erleichtern, können beim Strukturieren der Auflage außerdem Trennstellen in die Auflage eingefügt werden.

Weiterhin kann das Verfahren auch so weitergebildet sein, daß neben den Strukturen auf der Auflage funktionelle Strukturen auf einer Seite hergestellt werden, welche der Seite des Dies, welche die sensorisch aktive und/oder emittierende Einrichtung aufweist, gegenüberliegt. So können beispielsweise dem Bauelement von zwei Seiten kommend Signale zugeführt werden, ohne daß sensorische Funktionen auf der Seite des Bauelements, welches die sensorisch aktive und/oder emittierende Einrichtung aufweist, beeinträchtigt werden.

Die Erfindung sieht auch vor, ein elektronisches Bauelement mit einem hinsichtlich der oben genannten Nachteile elektronischer Bauelemente verbessertem Aufbau bereitzustellen. Dementsprechend weist ein erfindungsgemäßes elektronisches Bauelement, welches insbesondere nach dem oben beschriebenen Verfahren hergestellt ist und das wenigstens ein Halbleiterelement umfasst, eine sensorisch aktive und/oder emittierende Einrichtung auf einer ersten Seite auf, wobei das Halbleiterelement auf der ersten Seite mit einer strukturierten Auflage abgedeckt ist, welche außerdem zumindest eine für die sensorisch aktive und/oder emittierende Einrichtung funktionelle Struktur aufweist.

Die funktionellen Strukturen der Auflage können beispielsweise mittels Trockenätzen, nasschemischem Ätzen, mechanischem Schleifen, beziehungsweise Grinding, mechanischem Läppen, Bedampfen, Sputtern, CVD- oder PVD-Beschichten, Plating oder mittels Stencil Printing oder Belacken hergestellt worden sein.

Die strukturierte Auflage des elektronischen Bauelements kann dabei unter anderem als Abstandhalter dienen, um einen Abstand zwischen der sensorisch aktive und/oder emittierende Einrichtung des Halbleiterelements und einem funktionellen Element, wie beispielsweise einer Linse für ein opto-elektronisches Bauteil herzustellen.

Die strukturierte Auflage kann auch so ausgestaltet sein, daß sie eine Aufnahme definiert. Insbesondere können in einer solchen Aufnahme Fluide, optische Elemente, mikroelektronische Komponenten, aktive oder passive elektronische Elemente oder auch piezoelektrische Komponenten aufgenommen sein.

Auch kann die strukturierte Auflage vorteilhaft eine mechanische Passung aufweisen, wodurch unter anderem eine genau definierte Position eines darin eingepaßten Elements, wie etwa eines Wellenleiters ermöglicht wird.

Funktionelle Strukturen können sich für bestimmte Anwendungen erfindungsgemäßer Bauelemente jedoch nicht nur auf der Seite des Bauelements befinden, welche die sensorisch aktive und/oder emittierende Einrichtung aufweist. Vielmehr kann das Bauelement solche Strukturen auch auf der gegenüberliegenden Seite aufweisen.

Die Auflage auf dem Halbleiterelement kann insbesondere mehrere Lagen aufweisen, wobei diese Lagen auch aus verschiedenen Materialien zusammengesetzt sein können. Die Lagen können jeweils zumindest eine für die sensorisch aktive und/oder emittierende Einrichtung funktionelle Struktur aufweisen. Es kann sich dabei besonders um jeweils unterschiedliche funktionelle Strukturen handeln, die durch die Abfolge der Schichten oder Lagen miteinander kombiniert werden. So können beispielsweise für opto-elektronische Bauelemente Lagen, die einen Durchgang aufweisen und als Abstandhalter wirken, mit Lagen, die Linsen aufweisen, kombiniert werden. Ein solches Bauelement zeichnet sich dann durch eine komplexe, mehrelementige Optik aus, welche mit hoher Genauigkeit direkt auf dem Halbleiterelement aufgesetzt ist.

Die Erfindung wird nachfolgend anhand bevorzugter Ausführungsformen und unter Bezugnahme auf die beigefügten Zeichnungen näher erläutert. Dabei verweisen gleiche Bezugszeichen auf gleiche oder ähnliche Teile.

Es zeigen:
- Fig. 1A: einen Querschnitt durch eine Ausführungsform der Erfindung mit einer als Durchgang strukturierten Auflage,
- Fig. 1B: eine Variante der in Fig. 1A gezeigten Ausführungsform,
- Fig. 2: einen Querschnitt durch eine Ausführungsform der Erfindung mit einer als mechanische Passung für Kugellinsen strukturierten Auflage,
- Fig. 3: einen Querschnitt durch eine Ausführungsform der Erfindung mit einer als mechanische Passung für optische Linsen strukturierten Auflage,
- Fig. 4: einen Querschnitt durch eine Ausführungsform der Erfindung mit einer als mechanische Passung für einen Wellenleiter strukturierten Auflage,
- Fig. 5: einen Querschnitt durch eine Ausführungsform der Erfindung mit einer transparenten strukturierten Auflage mit Linse,
- Fig. 6: einen Querschnitt durch eine Abwandlung der in Fig. 5 dargestellten Ausführungsform der Erfindung mit einer Prismenlinse,
- Fig. 7: einen Querschnitt durch eine Ausführungsform der Erfindung mit einer mehrschichtigen strukturierten Auflage mit Linse,
- Fig. 8: einen Querschnitt durch eine Abwandlung der in Fig. 7 dargestellten Ausführungsform der Erfindung mit einer Prismenlinse,
- Fig. 9: eine weitere Ausführungsform mit mehrlagiger strukturierter Auflage,
- Fig. 10: eine Ausführungsform mit funktionellen Strukturen auf gegenüberliegenden Seiten des elektronischen Bauelements,
- Fig. 11: eine Ausführungsform mit Hohlräumen auf gegenüberliegenden Seiten des Halbleiterelements, und
- Fig. 12: einen Querschnitt durch einen im Waferverbund zusammengesetzten Stapel aus Wafer und strukturierter Auflage.

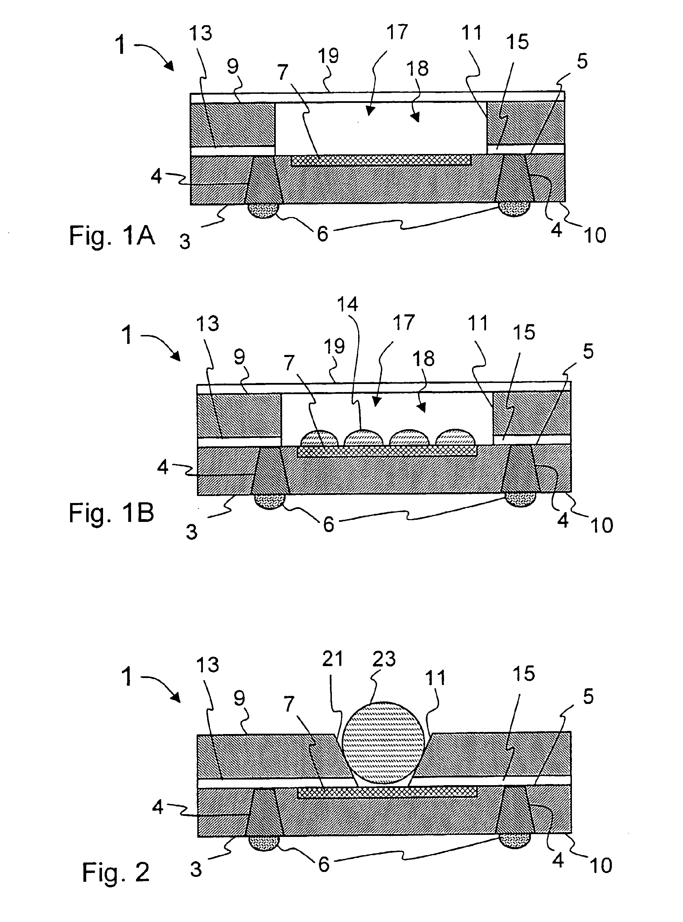

In Fig. 1A ist ein Querschnitt durch eine erste Ausführungsform eines im ganzen mit 1 bezeichneten erfindungsgemäßen elektronischen Bauelements dargestellt. Das elektronische Bauelement 1 umfaßt ein Halbleiterelement oder Die 3, welches auf einer ersten Seite 5, die im folgenden als Oberseite bezeichnet wird, eine sensorisch aktive und/oder emittierende Einrichtung 7 aufweist. Bei der sensorisch aktiven und/oder emittierenden Einrichtung 7 kann es sich beispielsweise um eine photoelektrische Schicht zur Wandlung elektrischer in optischer Signale oder umgekehrt handeln. Das Halbleiterelement 3 ist auf seiner Oberseite 5 mit der Unterseite 13 einer strukturierten Auflage 9 zusammengefügt. Die Verbindung von Bauelement 3 und strukturierter Auflage 9 wird mittels einer zwischen diesen Teilen befindlichen Verbindungsschicht 15 vermittelt.

Die strukturierte Auflage 9 weist als für die sensorisch aktive und/oder emittierende Einrichtung 7 funktionelle Struktur 11 eine Durchgangsöffnung 17 auf. Diese definiert zusammen mit der auf die Auflage 9 aufgebrachten Abdeckung 19 und der Oberseite 5 des Halbleiterelements 3 einen Hohlraum 18. Bei geeigneter Wahl der Verbindungsschicht 15 kann der Hohlraum 18 hermetisch von der Umgebung abgeschottet sein, so daß beispielsweise keine Feuchtigkeit eindringen kann. Eine derartige Verbindung zwischen Bauteil 3 und Auflage 9 kann unter anderem durch anodisches Bonden erzielt werden.

Durch den Hohlraum 18 wird im Falle eines opto-elektronischen Bauteils erreicht, daß dessen photoelektrische Schicht 7 von einem Medium mit niedrigem Brechungsindex umgeben ist. Ebenso kann der mittels der funktionellen Struktur 11 gebildete Hohlraum 18 als Aufnahme für ein Fluid dienen, etwa um mit einer speziell angepaßten sensorisch aktiven und/oder emittierenden Einrichtung 7 in der Form einer Sensorschicht chemische Analysen der Fluidphase vornehmen zu können.

Ein solcher Hohlraum 18 kann auch als Resonator dienen. Beispielsweise kann es sich bei der sensorisch aktiven und/oder emittierenden Einrichtung 7 auch um eine Einrichtung zur Erzeugung oder zum Nachweis von elektromagnetischen Hochfrequenzwellen, Mikrowellen oder Ultraschall handeln.

Weiterhin kann ein derartiger Hohlraum auch zur Verbesserung der Hochfrequenzeigenschaften des verpackten Bauteils dienen. Insbesondere kann dazu der Hohlraum ein Medium mit einer Dielektrizitätskonstante gleich 1 oder nahe 1 aufweisen. Beispielsweise kann der Hohlraum dazu evakuiert oder gasgefüllt sein. Der Hohlraum kann für den gleichen Zweck auch mit einem Low-k-Material aufgefüllt werden. Eine niedrige Dielektrizitätskonstante des Hohlraummediums hilft, parasitäre Kapazitäten des Halbleiter-Bauelements zu verringern. Low-k-Materialien können auch allgemein als Abdeckmaterialien der Auflage, insbesondere im Bereich der unmittelbaren Umgebung des Halbleiter-Bauelements und/oder dessen Zuleitungen verwendet werden.

Das elektronische Bauelement 1 kann außerdem so gefertigt werden, daß die Kontakte zum Anschluß des Bauelements auf dessen Unterseite 10 gelegt sind. Dazu können Durchkontaktierungen 4 durch das Substrat des Halbleiterelements erzeugt werden. Diese können beispielsweise durch Einfügen von Durchgängen in das Substrat hergestellt sein, die anschließend mit einem leitenden Material aufgefüllt werden. Auf den Durchkontaktierungen können für den Anschluß an eine Platine Lötperlen 6 aufgebracht sein.

Fig. 1B zeigt eine Variante der in Fig. 1A dargestellten Ausführungsform der Erfindung. Zur Herstellung des in Fig. 1B gezeigten elektronischen Bauelements 1 wird ebenfalls eine strukturierte Auflage 9 auf einen Wafer mit einem Halbleiterelement aufgebracht und dieses dann anschließend abgetrennt, wobei in der strukturierten Auflage eine dem Halbleiterelement 3 zugeordnete Durchgangsöffnung 17 eingefügt ist. Die Durchgangsöffnung definiert in mit dem Wafer zusammengefügten Zustand zusammen mit der Abdeckung 19 der Auflage 9 einen Hohlraum, welcher die Oberfläche der sensorisch aktiven oder emittierenden Einrichtung umgibt. Vor dem Zusammenfügen des Wafers mit der Auflage 9 wurden optische Elemente 14, wie beispielsweise Linsen oder Prismen direkt auf die Oberfläche der sensorisch aktiven oder emittierenden Einrichtung gesetzt. Beispielsweise können dazu Linsen durch Polymer-Reflow auf der Einrichtung 7 hergestelltwerden. Der Hohlraum 18 umschließt so nach dem Zusammenfügen auch diese optischen Elemente, so daß die sensorisch aktive oder emittierende Einrichtung 7 und die optischen Elemente 14 hermetisch abgeschlossen und vor Beschädigungen geschützt werden.

In Fig. 2 ist ein Querschnitt durch eine weitere Ausführungsform gezeigt. Hier definiert die funktionelle Struktur 11 der strukturierten Auflage 9 eine mechanische Passung 21 für ein optisches Element. Die Struktur 11 ist dabei bevorzugt in der Form eines Grabens ausgeführt der sich entlang einer Richtung senkrecht zur Papierebene erstreckt. Die Abmessungen des Grabens sind dazu geeignet, geschüttete Kugellinsen 23 aufzunehmen, von denen eine in der Figur gezeigt ist. Die Kugellinsen können nach dem Einfüllen mit einem transparenten Klebstoff mit der strukturierten Auflage 9 fixiert werden.

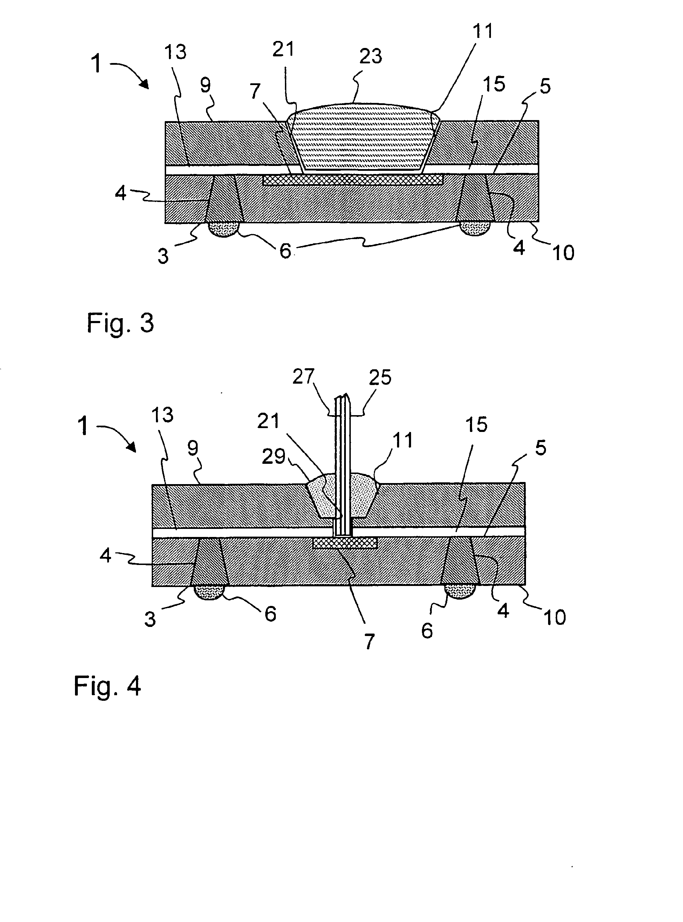

Fig. 3 zeigt eine weitere Ausführungsform des erfindungsgemäßen Bauelements 1, bei welcher die strukturierte Auflage 9 eine funktionelle Struktur 11 in der Form einer mechanischen Passung 21 aufweist. Die Form der Passung 21 ist passgenau an die Form einer optischen Linse 23 angeglichen. Die Linse kann nach dem Herstellen des Bauelements mit der Auflage in die Passung 21 eingesetzt werden. Der exakte Sitz der Linse wird dabei durch die genaue Ausrichtung der bereits im Waferverbund mit dem Halbleiterelement 3 zusammengefügten strukturierten Auflage 9 gewährleistet.

Fig. 4 zeigt eine Ausführungsform, bei welcher die Auflage 9 eine Passung 21 aufweist, welche zur Aufnahme und Positionierung eines Wellenleiters 25 dient. Nachdem der Wellenleiter 25 in die Passung 21 eingeführt worden ist, kann dieser mit einer Verklebung 29 am Bauteil 1 fixiert werden.

Durch die erfindungsgemäße Herstellung läßt sich die Auflage 9 und damit verbunden die Passung 21 so genau über dem Halbleiterelement 3 positionieren, daß die Sensor- oder Photoemitterschicht 7 entsprechend klein gehalten werden kann, da der lichtführende Wellenleiterkern 27 durch die Passung 21 entsprechend genau zu der Sensor- oder Photoemitterschicht 7 ausgerichtet wird. Auf diese Weise lassen sich dementsprechend auch die Abmessungen des Bauelements reduzieren oder auch mehrere Wellenleiter mit geringem Platzbedarf an ein opto-elektronisches Bauelement ankoppeln.

In allen vorangegangenen Beispielen war eine Transparenz der strukturierten Auflage nicht unbedingt erforderlich. Diese kann daher beispielsweise aus Halbleitermaterial gefertigt sein. Beispielsweise kann die Auflage auch dasselbe Material wie das Halbleiterelement aufweisen, wodurch das Bauteil aufgrund der gleichen Temperaturausdehnungs-koefizienten insgesamt temperaturunempfindlicher wird.

Die strukturierte Auflage 7 kann jedoch auch selbst funktionelle Strukturen in der Form von für die jeweilige Strahlungsart transparenten optischen Elementen aufweisen.

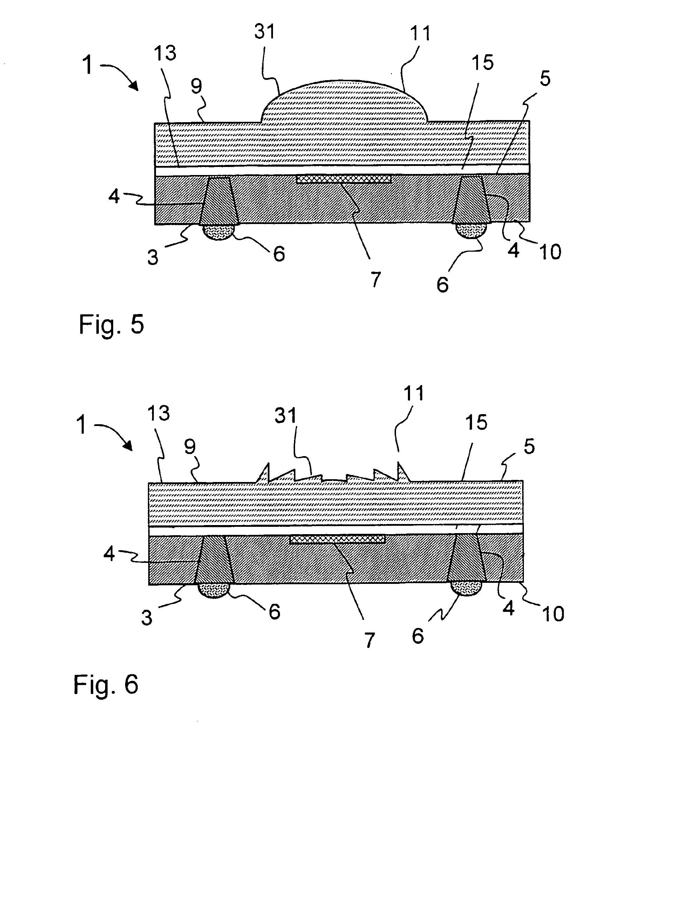

Eine solche Ausführungsform ist in Fig. 5 dargestellt. Hierbei umfaßt die Auflage 9 ein transparentes Material, wie beispielsweise Glas. Die funktionelle Struktur 11 umfaßt bei dieser Ausführungsform eine der sensorisch aktiven und/oder emittierenden Einrichtung 7 zugeordnete Linse 31, welche von der Einrichtung 7 emittiertes Licht bündeln oder auf das Bauelement 1 treffendes Licht auf die Einrichtung 7 fokussieren kann.

Das Material der Auflage kann neben für sichtbares Licht transparenten Werkstoffen wie Glas auch halbleitende Materialien wie GaAlAs umfassen, die für Infrarotlicht durchlässig sind.

In Fig. 6 ist eine Variante zu der in Fig. 5 gezeigten Ausführungsform dargestellt. Die funktionelle Struktur 11 der strukturierten Auflage umfaßt bei der in Fig. 6 gezeigten Variante eine Prismenlinse 31.

Die strukturierte Auflage 9 kann, wie in den vorangegangene Ausführungsbeispielen nicht nur eine einzelne Lage aufweisen. Vielmehr sind auch mehrlagige strukturierte Auflagen möglich, wobei das Zusammenfügen der Auflage mit dem Wafer, auf dem sich der Die für das Halbleiterelement befindet, im Waferverbund erfolgt. Die mehrlagige Auflage 9 kann so in jeder ihrer Lagen eine für die sensorisch aktive und/oder emittierende Einrichtung 7 funktionelle Struktur aufweisen.

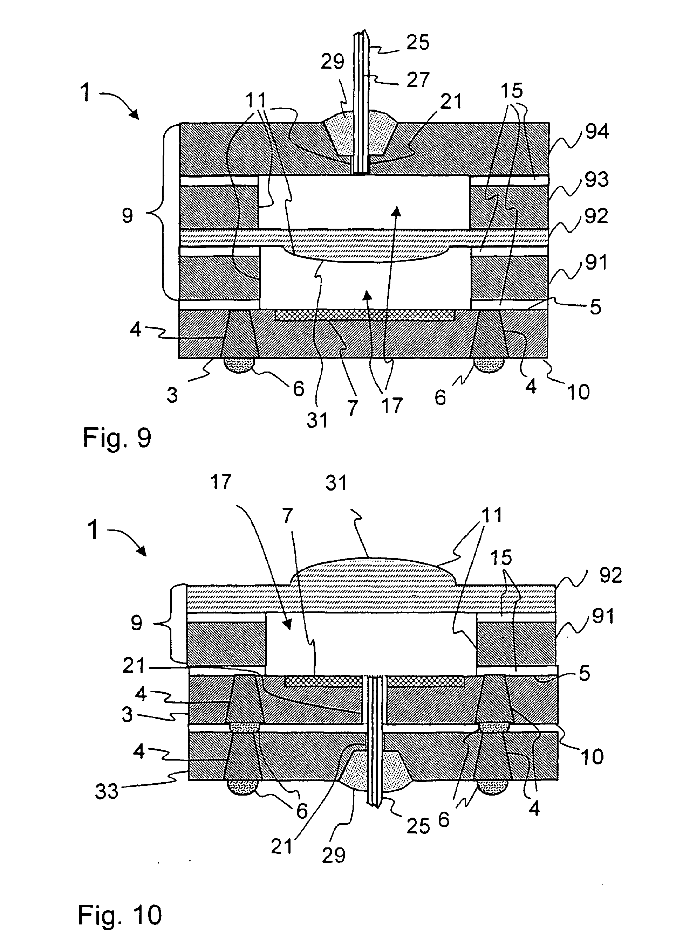

Beispiele solcher Ausführungsformen zeigen die Figuren 7 und 8. Hier umfaßt die strukturierte Auflage 9 zwei Lagen 91 und 92, welche über eine weitere Verbindungsschicht 15 miteinander verbunden sind. Die Lage 92 umfaßt in beiden Varianten ein transparentes Material, wie etwa Glas oder Kunststoff oder infrarotdurchlässiges GaAlAs und weist funktionelle Strukturen 11 in der Form zumindest einer Linse 11 auf.

Die Lage 92 dient als Abstandhalter der Linse zur sensorisch aktiven und/oder emittierenden Einrichtung 7. Als funktionelle Struktur ist ein Durchgang 17 in die Lage 91 eingefügt, welcher die Passage des von der Linse 31 gebündelten Lichts von und zur sensorisch aktiven und/oder emittierenden Einrichtung 7 ermöglicht.

Die in Fig. 8 gezeigte Variante unterscheidet sich von der in Fig. 7 gezeigten Variante darin, daß eine Prismenlinse anstelle einer konvexen Linsenstruktur wie in Fig. 7 verwendet wird.

Der Abstandhalter der anhand der Figuren 7 und 8 gezeigten Ausführungsformen erlaubt für die Fokussierung eine geringere Brennweite und reduziert dadurch beispielsweise die Bildfehler in der Ebene der sensorisch aktiven und/oder emittierenden Einrichtung 7.

Fig. 9 zeigt noch eine weitere Ausführungsform mit mehrlagiger strukturierter Auflage. Die Auflage 9 dieses Ausführungsbeispiels umfaßt 4 Lagen 91, 92, 93 und 94. Dabei sind die Lagen 91 und 93 ähnlich wie Lage 91 der anhand der Figuren 7 und 8 beschriebenen Ausführungsformen als Abstandhalter ausgebildet. Zwischen diesen beiden Lagen befindet sich eine Lage, welche als funktionelle Struktur 11 eine Linse 31 aufweist. Lage 94 weist eine Passung 21 für einen Wellenleiter 25 auf. Mit einem derartigen Aufbau können so entweder Lichtsignale, die aus dem Wellenleiterkern 27 austreten, auf die sensorisch aktive und/oder emittierende Einrichtung 7 fokussiert oder von der Einrichtung 7 emittiertes Licht präzise auf den Wellenleiterkern 27 gebündelt werden.

Die Schichtabfolge oder die funktionellen Strukturen der einzelnen Schichten sind selbstverständlich nicht auf die gezeigten Ausführungsbeispiele beschränkt. Vielmehr können diese je nach Anwendungszweck beliebig miteinander kombiniert werden. Insbesondere durch die Verwendung von Materialien, die im Temperaturausdehnungskoeffizient aufeinander angepaßt sind, können so auch komplexe und präzise Optiken für opto-elektronische Bauelemente hergestellt werden.

In Fig. 10 ist eine Ausführungsform dargestellt, bei welcher zusätzlich das Halbleiterelement selbst für die sensorisch aktive und/oder emittierende Einrichtung funktionelle Strukturen aufweist. Dementsprechend weist die Seite, welche der die sensorisch aktive und/oder emittierende Einrichtung 7 aufweisenden Seite des Halbleiterelements, gegenüberliegt, ebenfalls funktionelle Strukturen auf.

Die mehrlagige strukturierte Auflage 9 ist in diesem Ausführungsbeispiel ähnlich der anhand von Fig. 7 gezeigten Ausführungsform. Zusätzlich weist das Halbleiterelement 3 als funktionelle Struktur eine Passung für einen Wellenleiter auf, welcher von der Unterseite 10 her dem Bauelement 1 zugeführt wird. Zusätzlich umfaßt das elektronische Bauelement einen Chipstapel bestehend aus dem Halbleiterelement 3 mit der sensorisch aktiven und/oder emittierende Einrichtung 7 und einem weiteren Chip 33, auf welchen der Chip, beziehungsweise das Halbleiterelement 3 aufgesetzt ist. Das Aufsetzen kann ebenfalls wie das Zusammenfügen mit der Auflage im Waferverbund erfolgen. Das weitere Bauelement 33 weist ebenfalls eine Passung 21 auf, welche den Wellenleiter 25 führt und mit welcher dieser beispielsweise mittels einer Klebestelle 29 verbunden werden kann.

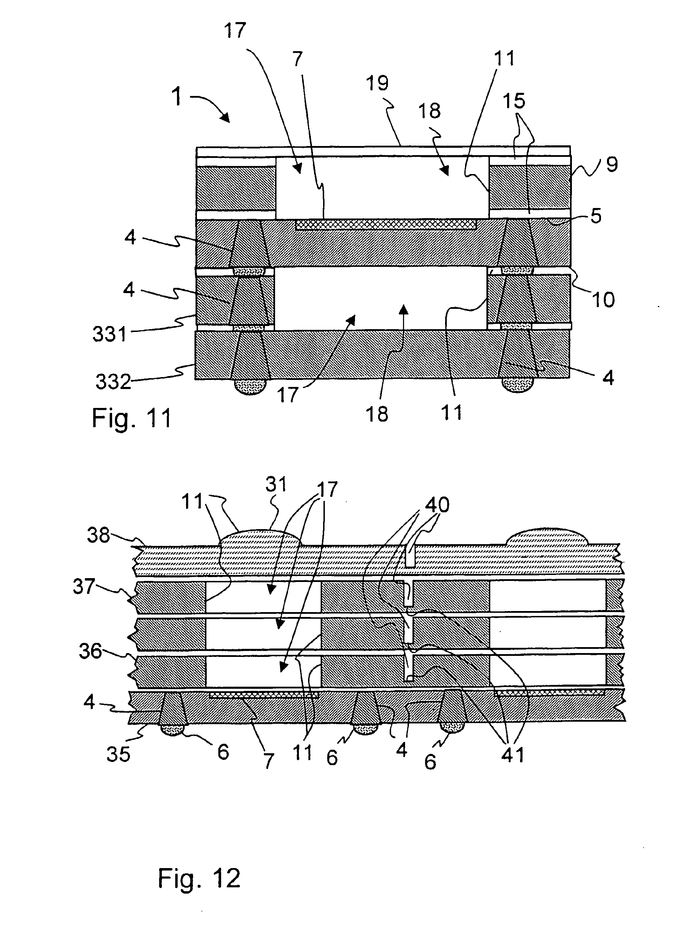

In Fig. 11 ist eine weitere Ausführungsform des elektronischen Bauelements gezeigt, welches Hohlräume 18 auf gegenüberliegenden Seiten des Halbleiterelements 3 aufweist. Die Hohlräume können beispielsweise als Cavities für Anwendungen in der Hochfrequenztechnik verwendet werden. Die Cavities, beziehungsweise Hohlräume werden durch die Wandungen der Durchgangsöffnungen 17 der strukturierten Auflage 9, beziehungsweise der strukturierten Unterlage 331 und den jeweiligen Abdeckungen gebildet. Die Abdeckung der strukturierten Unterlage 331 wird mit einer weiteren Unterlage 332 hergestellt, während die strukturierte Auflage 9 in dieser Ausführungsform mit einer Abdeckung 19 ähnlich wie bei dem anhand der Fig. 1A und 1B gezeigten Bauelemente versehen ist.

Der Gesamtaufbau der im Waferverbund zusammengefügten Teile kann insbesondere bei der Verwendung mehrlagiger Auflagen eine Dicke erreichen, die ein konventionelles Dicen nicht mehr ohne weiteres gestattet. Fig. 12 zeigt im Querschnitt einen Ausschnitt eines solchen Aufbaus im Waferverbund vor dem Dicen. Mit dem Wafer 35, welcher die Dies für die Halbleiterelemente 3 mit der sensorisch aktiven und/oder emittierenden Einrichtung 7 aufweist, sind weitere Wafer 36, 37, 38, 39 zusammengefügt, welche die strukturierte Auflage 9 bilden. Diese Auflage umfaßt Abstandhalter mit Durchgangsöffnungen 17 und einen Wafer mit einer refraktiven Struktur 11 in Form von integrierten Linsen 31. Dieser Aufbau bietet gegenüber einer massiven transparenten Auflage mit integrierten Linsen den Vorteil, daß bei gleicher Brechkraft eine relativ dünner transparenter Wafer 38 verwendet werden kann.

Um diese relativ dicke Struktur aus den Wafern 35 bis 38 trennen zu können, ist es vorteilhaft, wenn die Wafer wenigstens teilweise Trennstellen 40 aufweisen. Die Trennstellen sind über einzelne Stege 41 miteinander verbunden, um den Wafern die notwendige Stabilität für das Verpacken, beziehungsweise Zusammenfügen der Wafer 35 bis 38 im Waferverbund zu ermöglichen. Diese Stege lassen sich dann in einfacher Weise durch Nasschemisches oder trockenchemisches Ätzen oder durch Sägen auftrennen.

Alternativ zum Strukturieren von Trennstellen in den Wafern vor dem Zusammenfügen, können diese auch erst mit ihrer Unterlage zusammengefügt und dann strukturiert werden. Die Reihenfolge des Zusammenfügens und Strukturierens kann sich - außerdem für die einzelnen Lagen der Auflage auch abwechseln, was beispielsweise günstig sein kann, wenn die einzelnen Lagen unterschiedliche Materialien und/oder Dicken aufweisen. So kann beispielsweise die erste Lage der Auflage mit dem Halbleiterwafer, welcher die Dies aufweist, zusammengefügt und dann die Strukturierung vorgenommen werden, woraufhin anschließend als weitere Schicht der Auflage etwa eine vorstrukturierte Lage mit der ersten Lage zusammengefügt wird. Die Abfolge kann selbstverständlich in beliebiger Weise abgewandelt und auf beliebig viele Schichten angewendet werden.

Nach dem Vereinzeln, beziehungsweise dem Abtrennen vom Wafer können die Seitenwände dann anschließend gegebenenfalls passiviert werden. Dies kann beispielsweise durch geeignete Abscheideverfahren, wie nasschemisches Abscheiden, Bedampfen, Sputtern, CVD- oder PVD-Beschichten geschehen.

Der Waferstapel kann abschließend im Waferverbund oberflächenbehandelt werden. Beispielsweise können die optischen Eigenschaften der Linsen 31 durch eine Antireflexbeschichtung oder ein IR-Coating verbessert werden. Zur Erhöhung der Widerstandsfähigkeit können außerdem Antikratz- oder Korrosionsschutzschichten aufgebracht werden. Diese Beschichtungen lassen sich unter anderem in bekannter Weise durch CVD- oder PVD-Verfahren erzeugen.

Die in Fig. 12 gezeigte funktionelle Struktur 11 des Wafers, die ein Array von Linsen 31 umfasst, kann auch nach dem Erzeugen des Waferstapels auf diesen aufgebracht werden. Dabei können entweder anstelle des Wafers 38 einzelne Linsen aufgebracht werden, wie sie etwa in Fig. 3 gezeigt sind, oder diese Linsen können auf dem Stapel, beispielsweise als Polymer-Reflow-Linsen erzeugt werden.

### Bezugszeichenliste:

- Elektronisches Bauelement: 1
- Halbleiterelement, Die: 3
- Durchkontaktierung: 4
- Oberseite des Halbleiterelements: 5
- Lötperle: 6
- sensorisch aktive und/oder emittierende: 7
- Einrichtung Strukturierte Auflage: 9
- Lagen der strukturierten Auflage: 91, 92, 93, 94
- Unterseite des Halbleiterelements: 10
- funktionelle Struktur: 11
- Unterseite der strukturierten Auflage: 13
- optisches Element: 14
- Verbindungsschicht: 15
- Durchgangsöffnung: 17
- Hohlraum: 18
- Abdeckung: 19
- mechanische Passung: 21
- Linsen: 23, 31
- Wellenleiter: 25
- Wellenleiterkern: 27
- Klebstoff: 29
- Halbleiter-Unterlage: 33, 331, 7332
- Wafer: 35, 36, 37, 38
- Trennstelle: 40

## Patentansprüche

1. Verfahren zur Herstellung eines elektronischen Bauelements (1), welches wenigstens ein Halbleiterelement (3) umfasst, das auf zumindest einer Seite (5) zumindest eine sensorisch aktive und/oder emittierende Einrichtung (7) aufweist, wobei das Verfahren die Schritte umfaßt:
- Bereitstellen zumindest eines Dies auf einem Wafer (35), wobei das elektronische Bauelement so gefertigt wird, dass Kontakte zum Anschluß des Bauelements auf dessen Unterseite (10) gelegt sind und Durchkontaktierungen (4) durch das Substrat des Halbleiterelements erzeugt werden,
- Herstellen zumindest einer strukturierten Auflage (9), welche zumindest eine für die sensorisch aktive und/oder emittierende Einrichtung (7) funktionelle Struktur (11) aufweist,
- Zusammenfügen des Wafers (35) mit der zumindest einen Auflage (9), so daß die Seite des Dies (5), welche die sensorisch aktive und/oder emittierende Einrichtung (7) aufweist, der Auflage (9) zugewandt ist,
- Abtrennen des Dies.

2. Verfahren nach Anspruch 1, **dadurch gekennzeichnet, daß** der Schritt des Herstellens einer strukturierten Auflage (9) den Schritt des Herstellens einer mehrlagigen strukturierten Auflage umfaßt.

3. Verfahren nach Anspruch 2, wobei der Schritt des Herstellens einer mehrlagigen strukturierten Auflage den Schritt des Herstellens zumindest einer für die sensorisch aktive und/oder emittierende Einrichtung (7) funktionellen Struktur (11) in jeder Lage (91, 92, 93, 94) der mehrlagigen strukturierten Auflage (9).

4. Verfahren nach Anspruch 2 oder 3, wobei der Schritt des Zusammenfügens des Wafers (35) mit der zumindest einen Auflage (9) den Schritt des nacheinander Anfügens der Lagen (91, 92, 93, 94) auf den Wafer (3) umfaßt.

5. Verfahren nach einem der Ansprüche 1 bis 4, wobei der Schritt des Herstellens einer strukturierten Auflage den Schritt des Strukturierens der mit dem Wafer (35) zusammengefügten Auflage umfaßt.

6. Verfahren nach einem der Ansprüche 1 bis 5, wobei der Schritt des Herstellens einer strukturierten Auflage den Schritt des Vorfertigens von Strukturen (11) der Auflage (9) umfaßt.

7. Verfahren nach einem der Ansprüche 1 bis 6, wobei der Schritt des Herstellens einer strukturierten Auflage (9) den Schritt des lithographischen Strukturierens der Auflage umfaßt.

8. Verfahren nach einem der Ansprüche 1 bis 7, wobei der Schritt des Strukturierens den Schritt des Strukturierens mittels Trockenätzen und/oder nasschemischem Ätzen und/oder mechanisches Schleifen und/oder mechanisches Läppen umfaßt.

9. Verfahren nach einem der Ansprüche 1 bis 8, wobei der Schritt des Strukturierens den Schritt des Strukturierens mittels Bedampfen und/oder Sputtern und/oder CVD-Beschichten und/oder PVD-Beschichten und/oder Plating und/oder mittels Stencil Printing und Belackung umfaßt.

10. Verfahren nach einem der Ansprüche 1 bis 9, wobei der Schritt des Herstellens einer strukturierten Auflage den Schritt des Herstellens eines Abstandhalters, insbesondere für zumindest ein optisches Element (23, 25 31) umfaßt.

11. Verfahren nach einem der Ansprüche 1 bis 10, wobei der Schritt des Herstellens einer strukturierten Auflage den Schritt des Herstellens einer Aufnahme (17), insbesondere für Fluide, optische Elemente, piezoelektrische Komponenten, mikroelektronische Komponenten und/oder aktive oder passive elektronische Elemente umfaßt.

12. Verfahren nach einem der Ansprüche 1 bis 11, wobei der Schritt des Herstellens einer strukturierten Auflage den Schritt des Herstellens zumindest eines Hohlraums umfaßt, insbesondere eines Resonatorraums oder eines Hohlraums, welcher die Oberfläche der sensorisch aktiven und/oder emittierende Einrichtung (7) oder auf dieser angeordnete optische Elemente umgibt.

13. Verfahren nach einem der Ansprüche 1 bis 12, wobei der Schritt des Herstellens einer strukturierten Auflage den Schritt des Herstellens zumindest eines Grabens, insbesondere einer V-Nut umfaßt, wobei der Graben sich vorzugsweise in einer Richtung entlang der Oberfläche der Auflage erstreckt.

14. Verfahren nach einem der Ansprüche 1 bis 13, wobei der Schritt des Herstellens einer strukturierten Auflage den Schritt des Herstellens einer mechanischen Passung (21) umfaßt.

15. Verfahren nach Anspruch 14, wobei die mechanische Passung (21) für die Aufnahme eines optischen Elements (23, 25), insbesondere eines Wellenleiters (25) geeignet ist.

16. Verfahren nach einem der Ansprüche 1 bis 15, wobei der Schritt des Herstellens einer strukturierten Auflage den Schritt des Herstellens einer Auflage umfaßt, welche optische Komponenten (31) aufweist.

17. Verfahren nach Anspruch 16, wobei der Schritt des Herstellens einer Auflage, welche optische Komponenten aufweist, den Schritt des Herstellens von Linsen (31), insbesondere konkaven und/oder konvexen Linsen und/oder-Fresnel-Linsen und/oder Prismenlinsen und/oder den Schritt des Herstellens von Gittern, insbesondere Phasengittern und/oder von Prismen umfaßt.

18. Verfahren nach einem der Ansprüche 1 bis 17, wobei der Schritt des Herstellens einer strukturierten Auflage den Schritt des Herstellens zumindest eines Durchgangs (17) durch die Auflage umfaßt.

19. Verfahren nach einem der Ansprüche 1 bis 18, wobei der Schritt des Zusammenfügens des Wafers (35) mit der zumindest einen strukturierten Auflage den Schritt des Zusammenfügens mit zumindest einer weiteren als Abstandhalter wirkenden Auflage umfaßt.

20. Verfahren nach einem der Ansprüche 1 bis 19, wobei die Auflage ein Material aus einer Gruppe aufweist, die Halbleitermaterialien, insbesondere Silizium und/oder Galliumarsenid und/oder Indiumphosphid; Gläser, insbesondere Quarzglas; Calziumfluorid; Metall; Glasschaum; Metallschaum; Low-k-Dielektrika; Saphir, insbesondere Saphirglas; Verbundwerkstoffe; Keramiken und Kunststoffe umfaßt.

21. Verfahren nach einem der Ansprüche 1 bis 20, wobei der Wafer (35) und die Auflage (9) ein gleiches Material umfassen.

22. Verfahren nach einem der Ansprüche 1 bis 21, wobei die Auflage und der Wafer an den einander zugewandten Grenzflächen aufeinander angepaßte Temperaturausdehnungskoeffizienten aufweisen.

23. Verfahren nach einem der Ansprüche 1 bis 22, wobei der Schritt des Zusammenfügens des Wafers mit der Auflage den Schritt des anodischen Bondens des Wafers mit der Auflage umfaßt.

24. Verfahren nach einem der Ansprüche 1 bis 23, wobei der Schritt des Zusammenfügens des Wafers mit der Auflage den Schritt des Verklebens des Wafers mit der Auflage umfaßt.

25. Verfahren nach Anspruch 24, wobei der Schritt des Verklebens des Wafers mit der Auflage den Schritt des Verklebens mit Polymeren und/oder Epoxyklebern umfaßt.

26. Verfahren nach einem der Ansprüche 1 bis 25, wobei der Schritt des Zusammenfügens des Wafers mit der Auflage den Schritt des Metallisierens von Bereichen des Wafers und/oder der Auflage und den Schritt des Legierungslötens der metallisierten Bereiche umfaßt.

27. Verfahren nach einem der Ansprüche 1 bis 26, wobei der Schritt des Zusammenfügens des Wafers mit der Auflage den Schritt des Diffusionsverschweißens und/oder des Glaslötens umfaßt.

28. Verfahren nach einem der Ansprüche 1 bis 27, wobei der Schritt des Herstellens zumindest einer strukturierten Auflage den Schritt des Erzeugens von Trennstellen (40) in der zumindest einen Auflage umfaßt.

29. Verfahren nach einem der Ansprüche 1 bis 28, weiter **gekennzeichnet durch** den Schritt des Herstellens zumindest einer von für die sensorisch aktive und/oder emittierende Einrichtung (7) funktionellen Struktur (11) auf einer Seite, welche der Seite des Dies, welche die sensorisch aktive und/oder emittierende Einrichtung (7) aufweist, gegenüberliegt.

30. Elektronisches Bauelement (1), welches wenigstens ein Halbleiterelement (3) umfasst, das zumindest eine sensorisch aktive und/oder emittierende Einrichtung (7) auf zumindest einer ersten Seite (5) aufweist, insbesondere hergestellt nach einem der Ansprüche 1 bis 28, **dadurch gekennzeichnet, daß** das Halbleiterelement (3) auf der ersten Seite (5) mit einer strukturierten Auflage (9) abgedeckt ist, welche zumindest eine für die sensorisch aktive und/oder emittierende Einrichtung (7) funktionelle Struktur aufweist,
wobei das elektronische Bauelement so gefertigt ist, dass Kontakte zum Anschluß des Bauelements auf dessen Unterseite (10) gelegt und Durchkontaktierungen (4) durch das Substrat des Halbleiterelements erzeugt sind.

31. Elektronisches Bauelement nach Anspruch 30, wobei die funktionellen Strukturen mittels Trockenätzen und/oder nasschemischem Ätzen und/oder mechanisches Schleifen und/oder mechanisches Läppen, Bedampfen und/oder Sputtern und/oder CVD-Beschichten und/oder PVD-Beschichten und/oder Plating und/oder mittels Stencil Printing und/oder Belacken hergestellt sind.

32. Elektronisches Bauelement nach Anspruch 30 oder 31, wobei die strukturierte Auflage einen Abstandhalter, insbesondere für zumindest ein optisches Element (23, 25, 31) aufweist.

33. Elektronisches Bauelement nach Anspruch 30, 31 oder 32, wobei die strukturierte Auflage zumindest eine Aufnahme, insbesondere für ein Fluid aufweist.

34. Elektronisches Bauelement nach einem der Ansprüche 30 bis 33, wobei die strukturierte Auflage eine mechanische Passung (21) aufweist.

35. Elektronisches Bauelement nach Anspruch 34, wobei die mechanische Passung für die Aufnahme eines optischen Elements (23, 25), insbesondere eines Wellenleiters (25), und/oder einer mikroelektronischen Komponente und/oder einer piezoelektrischen Komponente geeignet ist.

36. Elektronisches Bauelement nach einem der Ansprüche 30 bis 35, wobei die Auflage mit dem Halbleiterelement (3) durch anodisches Bonden miteinander verbunden sind.

37. Elektronisches Bauelement nach einem der Ansprüche 30 bis 36, wobei die Auflage mit dem Halbleiterelement (3) insbesondere mit Polymeren und/oder Epoxyklebern und/oder Glaslot verklebt und/oder verlötet und/oder diffusionsverschweißt sind.

38. Elektronisches Bauelement nach einem der Ansprüche 30 bis 37, **dadurch gekennzeichnet, daß** auf einer Seite (10), welche der Seite (5) des Halbleiterelements (3), welche die sensorisch aktive und/oder emittierende Einrichtung (7) aufweist, gegenüberliegt, zumindest eine funktionelle Struktur (11) aufweist.

39. Elektronisches Bauelement nach einem der Ansprüche 30 bis 38, **dadurch gekennzeichnet, daß** die Auflage zumindest einen Durchgang (17) aufweist.

40. Elektronisches Bauelement nach einem der Ansprüche 30 bis 39, **dadurch gekennzeichnet, daß** die Auflage mehrere Lagen (91, 92, 93, 94) aufweist.

41. Elektronisches Bauelement nach Anspruch 40, **dadurch gekennzeichnet, daß** die Lagen (91, 92, 93, 94) jeweils zumindest eine für die sensorisch aktive und/oder emittierende Einrichtung funktionelle Struktur (11) aufweisen.

42. Elektronisches Bauelement nach einem der Ansprüche 30 bis 41, **dadurch gekennzeichnet, daß** die Auflage zumindest einen Hohlraum, insbesondere einen Resonatorraum aufweist.

43. Elektronisches Bauelement nach einem der Ansprüche 30 bis 42, **dadurch gekennzeichnet, daß** die Auflage zumindest einen Graben, insbesondere eine V-Nut aufweist, wobei der Graben sich vorzugsweise in einer Richtung entlang der Oberfläche der Auflage erstreckt.

## Claims

1. Method for producing an electronic component (1) which includes at least one semiconductor element (3) which comprises on at least one side (5) at least one sensorically active and / or emitting device (7), whereby the method comprises the steps:
- provision of at least one die on a wafer (35), whereby the electronic component is produced in such a way that contacts for connecting the component are placed on its lower side (10) and through contacts (4) are produced through the substrate of the semiconductor element,
- production of at least one structured support (9) which comprises at least one structure (11) which is functional for the sensorically active and / or emitting device (7),
- joining of the wafer (35) to the at least one support (9) so that the side of the die (5) which comprises the sensorically active and / or emitting device (7) is facing the support (9),
- separation of the die.

2. Method according to claim 1, **characterised in that** the step of producing a structured support (9) includes the step of producing a multi-layer structured support.

3. Method according to claim 2, wherein the step of producing a multi-layer structured support includes the step of producing at least one structure (11) which is functional for the sensorically active and / or emitting device (7) in each layer (91, 92, 93, 94) of the multilayer structured support (9).

4. Method according to claim 2 or 3, wherein the step of joining the wafer (35) to the at least one support (9) includes the step of adding the layers (91, 92, 93, 94) one after the other to the wafer (3).

5. Method according to one of the claims 1 to 4, wherein the step of producing a structured support includes the step of structuring the support joined to the wafer (35).

6. Method according to one of the claims 1 to 5, wherein the step of producing a structured support includes the step of pre-manufacturing structures (11) of the support (9).

7. Method according to one of the claims 1 to 6, wherein the step of producing a structured support (9) includes the step of lithographic structuring of the support.

8. Method according to one of the claims 1 to 7, wherein the step of structuring includes the step of structuring by means of dry etching and / or wet chemical etching and / or mechanical grinding and / or mechanical lapping.

9. Method according to one of the claims 1 to 8, wherein the step of structuring includes the step of structuring by means of evaporation and / or sputtering and / or CVD coating and / or PVD coating and / or plating and / or by means of stencil printing and lacquering.

10. Method according to one of the claims 1 to 9, wherein the step of producing a structured support includes the step of producing a spacer, particularly for at least one optical element (23, 25, 31).

11. Method according to one of the claims 1 to 10, wherein the step of producing a structured support includes the step of producing a receiving element (17), particularly for fluids, optical elements, piezoelectric components, microelectronic components and / or active or passive electronic elements.

12. Method according to one of the claims 1 to 11, wherein the step of producing a structured support includes the step of producing at least one hollow space, particularly a resonator space or a hollow space which surrounds the surface of the sensorically active and / or emitting device (7) or optical elements arranged on this.

13. Method according to one of the claims 1 to 12, wherein the step of producing a structured support includes the step of producing at least one trench, particularly a V-shaped groove, wherein the trench preferably extends in a direction along the surface of the support.

14. Method according to one of the claims 1 to 13, wherein the step of producing a structured support includes the step of producing a mechanical fit (21).

15. Method according to claim 14, wherein the mechanical fit (21) can receive an optical element (23, 25), particularly a waveguide (25).

16. Method according to one of the claims 1 to 15, wherein the step of producing a structured support includes the step of producing a support which comprises optical components (31).

17. Method according to claim 16, wherein the step of producing a support which comprises optical components includes the step of producing lenses (31), particularly concave and / or convex lenses and / or Fresnel lenses and / or prism lenses and / or the step of producing gratings, particularly phase gratings and / or prisms.

18. Method according to one of the claims 1 to 17, wherein the step of producing a structured support includes the step of producing at least one passage (17) through the support.

19. Method according to one of the claims 1 to 18, wherein the step of joining the wafer (25) to the at least one structured support includes the step of joining it to at least one further support acting as a spacer.

20. Method according to one of the claims 1 to 19, wherein the support comprises a material from a group which includes semiconductor materials, particularly silicon and / or gallium arsenide and / or indium phosphide; glasses, particularly vitreous silica; calcium fluoride; metal; glass foam; metal foam; low k dielectrica; sapphire, particularly sapphire glass; composite materials; ceramics and plastics.

21. Method according to one of the claims 1 to 20, wherein the wafer (35) and the support (9) comprise the same material.

22. Method according to one of the claims 1 to 21, wherein the support and the wafer have temperature expansion coefficients adapted to each other on the boundary surfaces facing each other.

23. Method according to one of the claims 1 to 22, wherein the step of joining the wafer to the support includes the step of anodic bonding of the wafer with the support.

24. Method according to one of the claims 1 to 23, wherein the step of joining the wafer to the support includes the step of sticking the wafer to the support.

25. Method according to claim 24, wherein the step of sticking the wafer to the support includes the step of sticking with polymers and / or epoxy adhesives.

26. Method according to one of the claims 1 to 25, wherein the step of joining the wafer to the support includes the step of metallising areas of the wafer and / or of the support and the step of alloy soldering the metallised areas.

27. Method according to one of the claims 1 to 26, wherein the step of joining the wafer to the support includes the step of diffusion welding and / or glass soldering.

28. Method according to one of the claims 1 to 27, wherein the step of producing at least one structured support includes the step of producing separating points (40) in the at least one support.

29. Method according to one of the claims 1 to 28, further **characterised by** the step of producing at least one structure (11) which is functional for the sensorically active and / or emitting device (7) on one side which lies opposite the side of the die which comprises the sensorically active and / or emitting device (7).

30. Electronic component (1) which includes at least one semiconductor element (3) which comprises at least one sensorically active and / or emitting device (7) on at least a first side (5), in particular produced according to one of the claims 1 to 28, **characterised in that** the semiconductor element (3) is covered on the first side (5) with a structured support (9) which comprises at least one structure which is functional for the sensorically active and / or emitting device (7), wherein the electronic component is produced in such a way that contacts for connecting the component are placed on its lower side (10) and through contacts (4) are produced through the substrate of the semiconductor element.

31. Electronic component according to claim 30, wherein the functional structures are produced by means of dry etching and / or wet chemical etching and / or mechanical grinding and / or mechanical lapping, evaporation and / or sputtering and / or CVD coating and / or PVD coating and / or plating and / or by means of stencil printing and / or lacquering.

32. Electronic component according to claim 30 or 31, wherein the structured support comprises a spacer, in particular for at least one optical element (23, 25, 31).

33. Electronic component according to claim 30, 31 or 32, wherein the structured support comprises at least one receiving element, particularly for a fluid.

34. Electronic component according to one of the claims 30 to 33, wherein the structured support comprises a mechanical fit (21).

35. Electronic component according to claim 34, wherein the mechanical fit can receive an optical element (23, 25), particularly a waveguide (25), and / or a microelectronic component and / or a piezoelectric component.

36. Electronic component according to one of the claims 30 to 35, wherein the support is connected to the semiconductor element (3) by anodic bonding.

37. Electronic component according to one of the claims 30 to 36, wherein the support is stuck to the semiconductor element (3), in particular with polymers and / or epoxy adhesives and / or glass solder, and / or soldered and / or diffusion welded.

38. Electronic component according to one of the claims 30 to 37, **characterised in that** one side (10) which lies opposite the side (5) of the semiconductor element (3) which comprises the sensorically active and / or emitting device (7) comprises at least one functional structure (11).

39. Electronic component according to one of the claims 30 to 38, **characterised in that** the support comprises at least one passage (17).

40. Electronic component according to one of the claims 30 to 39, **characterised in that** the support comprises a plurality of layers (91, 92, 93, 94).

41. Electronic component according to claim 40, **characterised in that** the layers (91, 92, 93, 94) each comprise at least one structure (11) which is functional for the sensorically active and / or emitting device.

42. Electronic component according to one of the claims 30 to 41, **characterised in that** the support comprises at least one hollow space, particularly a resonator space.

43. Electronic component according to one of the claims 30 to 42, **characterised in that** the support comprises at least one trench, particularly a V-shaped groove, wherein the trench preferably extends n a direction along the surface of the support.

## Revendications

1. Procédé de fabrication d'un composant électronique (1) qui comprend au moins un élément semi-conducteur (3) qui comporte sur au moins un côté (5) au moins un dispositif émetteur et/ou actif sur le plan sensoriel (7), le procédé comprenant les étapes de :
- préparation d'au moins une puce (du type "die") sur une tranche semi-conductrice (35), le composant électronique étant fabriqué de telle sorte que des contacts destinés au raccordement du composant sont placés sur le dessous (10) de celui-ci et des contacts traversants (4) sont produits à travers le substrat de l'élément semi-conducteur,
- fabrication d'au moins un support structuré (9) qui comporte au moins une structure fonctionnelle (11) pour le dispositif émetteur et/ou actif sur le plan sensoriel (7),
- assemblage de la tranche semi-conductrice (35) avec le ou les supports (9) de telle sorte que le côté de la puce (5) qui comporte le dispositif émetteur et/ou actif sur le plan sensoriel (7) est orienté vers le support (9),
- séparation de la puce.

2. Procédé selon la revendication 1, **caractérisé par le fait que** l'étape de fabrication d'un support structuré (9) comprend l'étape de fabrication d'un support structuré à plusieurs couches.

3. Procédé selon la revendication 2, dans lequel l'étape de fabrication d'un support structuré à plusieurs couches comprend l'étape de fabrication d'au moins une structure fonctionnelle (11) pour le dispositif émetteur et/ou actif sur le plan sensoriel (7) dans chaque couche (91, 92, 93, 94) du support structuré à plusieurs couches (9).

4. Procédé selon la revendication 2 ou 3, dans lequel l'étape d'assemblage de la tranche semi-conductrice (35) avec le ou les supports (9) comprend l'étape consistant à joindre successivement les couches (91, 92, 93, 94) sur la tranche semi-conductrice (3).

5. Procédé selon l'une des revendications 1 à 4, dans lequel l'étape de fabrication d'un support structuré comprend l'étape de structuration du support assemblé avec la tranche semi-conductrice (35).

6. Procédé selon l'une des revendications 1 à 5, dans lequel l'étape de fabrication d'un support structuré comprend l'étape de préfabrication de structures (11) du support (9).

7. Procédé selon l'une des revendications 1 à 6, dans lequel l'étape de fabrication d'un support structuré (9) comprend l'étape de structuration lithographique du support.

8. Procédé selon l'une des revendications 1 à 7, dans lequel l'étape de structuration comprend l'étape de structuration au moyen d'une gravure à sec et/ou d'une gravure chimique par voie humide et/ou d'un meulage mécanique et/ou d'un rodage mécanique.

9. Procédé selon l'une des revendications 1 à 8, dans lequel l'étape de structuration comprend l'étape de structuration au moyen d'une vaporisation et/ou d'une pulvérisation et/ou d'un revêtement CVD et/ou d'un revêtement PVD et/ou d'un placage et/ou au moyen d'une impression au stencil et d'un laquage.

10. Procédé selon l'une des revendications 1 à 9, dans lequel l'étape de fabrication d'un support structuré comprend l'étape de fabrication d'un élément d'écartement, notamment pour au moins un élément optique (23, 25, 31).

11. Procédé selon l'une des revendications 1 à 10, dans lequel l'étape de fabrication d'un support structuré comprend l'étape de fabrication d'un logement (17), notamment pour des fluides, des éléments optiques, des composants piézo-électriques, des composants microélectroniques et/ou des éléments électroniques actifs ou passifs.

12. Procédé selon l'une des revendications 1 à 11, dans lequel l'étape de fabrication d'un support structuré comprend l'étape de fabrication d'au moins une cavité, notamment d'un espace de résonateur ou d'une cavité qui entoure la surface du dispositif émetteur et/ou actif sur le plan sensoriel (7) ou des éléments optiques agencés sur celui-ci.

13. Procédé selon l'une des revendications 1 à 12, dans lequel l'étape de fabrication d'un support structuré comprend l'étape de fabrication d'au moins une tranchée, notamment d'une rainure en V, la tranchée s'étendant de préférence dans une direction le long de la surface du support.

14. Procédé selon l'une des revendications 1 à 13, dans lequel l'étape de fabrication d'un support structuré comprend l'étape de fabrication d'un ajustement mécanique (21).

15. Procédé selon la revendication 14, dans lequel l'ajustement mécanique (21) convient au logement d'un élément optique (23, 25), notamment d'un guide d'ondes (25).

16. Procédé selon l'une des revendications 1 à 15, dans lequel l'étape de fabrication d'un support structuré comprend l'étape de fabrication d'un support qui comporte des composants optiques (31).

17. Procédé selon la revendication 16, dans lequel l'étape de fabrication d'un support qui comporte des composants optiques comprend l'étape de fabrication de lentilles (31), notamment de lentilles concaves et/ou convexes et/ou de lentilles de Fresnel et/ou de lentilles prismatiques et/ou l'étape de fabrication de réseaux, notamment de réseaux de phases et/ou de prismes.

18. Procédé selon l'une des revendications 1 à 17, dans lequel l'étape de fabrication d'un support structuré comprend l'étape de fabrication d'au moins un passage (17) à travers le support.

19. Procédé selon l'une des revendications 1 à 18, dans lequel l'étape d'assemblage de la tranche semi-conductrice (35) avec le ou les supports structurés comprend l'étape d'assemblage avec au moins un autre support servant d'élément d'écartement.

20. Procédé selon l'une des revendications 1 à 19, dans lequel le support comporte au moins un matériau parmi un groupe de matériaux comprenant des matériaux semiconducteurs, notamment du silicium et/ou de l'arséniure de gallium et/ou du phosphure d'indium ; des verres, notamment du verre quartzeux ; du fluorure de calcium ; des métaux ; de la mousse de verre ; de la mousse de métal ; des diélectriques low-k ; du saphir, notamment du verre de saphir ; des matériaux composites ; des céramiques et des matériaux plastiques.

21. Procédé selon l'une des revendications 1 à 20, dans lequel la tranche semi-conductrice (35) et le support (9) comprennent un même matériau.

22. Procédé selon l'une des revendications 1 à 21, dans lequel le support et la tranche semi-conductrice ont des coefficients de dilatation thermique adaptés l'un à l'autre aux surfaces limites orientées l'une vers l'autre.

23. Procédé selon l'une des revendications 1 à 22, dans lequel l'étape d'assemblage de la tranche semi-conductrice avec le support comprend l'étape de liaison anodique de la tranche semi-conductrice avec le support.

24. Procédé selon l'une des revendications 1 à 23, dans lequel l'étape d'assemblage de la tranche semi-conductrice avec le support comprend l'étape de collage de la tranche semi-conductrice avec le support.

25. Procédé selon la revendication 24, dans lequel l'étape de collage de la tranche semi-conductrice avec le support comprend l'étape de collage avec des polymères et/ou des colles époxy.

26. Procédé selon l'une des revendications 1 à 25, dans lequel l'étape d'assemblage de la tranche semi-conductrice avec le support comprend l'étape de métallisation de zones de la tranche semi-conductrice et/ou du support et l'étape de brasage d'alliage des zones métallisées.

27. Procédé selon l'une des revendications 1 à 26, dans lequel l'étape d'assemblage de la tranche semi-conductrice avec le support comprend l'étape de soudage par diffusion et/ou de brasage de verre.

28. Procédé selon l'une des revendications 1 à 27, dans lequel l'étape de fabrication d'au moins un support structuré comprend l'étape de production de points de rupture (40) dans le ou les supports.

29. Procédé selon l'une des revendications 1 à 28, également **caractérisé par** l'étape de fabrication d'au moins une structure fonctionnelle (11), pour le dispositif émetteur et/ou actif sur le plan sensoriel (7), sur un côté qui est en face de celui des côtés de la puce qui comporte le dispositif émetteur et/ou actif sur le plan sensoriel (7) .

30. Composant électronique (1), qui comprend au moins un élément semi-conducteur (3), qui comporte au moins un dispositif émetteur et/ou actif sur le plan sensoriel (7) sur au moins un premier côté (5), fabriqué notamment selon l'une des revendications 1 à 28, **caractérisé par le fait que** l'élément semi-conducteur (3) sur le premier côté (5) est recouvert avec un support structuré (9) qui comporte au moins une structure fonctionnelle pour le dispositif émetteur et/ou actif sur le plan sensoriel (7),
le composant électronique étant fabriqué de telle sorte que des contacts destinés au raccordement du composant sont placés sur le dessous (10) de celui-ci et des contacts traversants (4) sont produits à travers le substrat de l'élément semi-conducteur.

31. Composant électronique selon la revendication 30, dans lequel les structures fonctionnelles sont fabriquées au moyen d'une gravure à sec et/ou d'une gravure chimique par voie humide et/ou d'un meulage mécanique et/ou d'un rodage mécanique, d'une vaporisation et/ou d'une pulvérisation et/ou d'un revêtement CVD et/ou d'un revêtement PVD et/ou d'un placage et/ou au moyen d'une impression au stencil et/ou d'un laquage.

32. Composant électronique selon la revendication 30 ou 31, dans lequel le support structuré comporte un élément d'écartement, notamment pour au moins un élément optique (23, 25, 31).

33. Composant électronique selon la revendication 30, 31 ou 32, dans lequel le support structuré comporte au moins un logement, notamment pour un fluide.

34. Composant électronique selon l'une des revendications 30 à 33, dans lequel le support structuré comporte un ajustement mécanique (21).

35. Composant électronique selon la revendication 34, dans lequel l'ajustement mécanique convient au logement d'un élément optique (23, 25), notamment d'un guide d'ondes (25), et/ou d'un composant micro-électronique et/ou d'un composant piézo-électrique.

36. Composant électronique selon l'une des revendications 30 à 35, dans lequel le support et l'élément semi-conducteur (3) sont reliés l'un à l'autre par liaison anodique.

37. Composant électronique selon l'une des revendications 30 à 36, dans lequel le support et l'élément semi-conducteur (3) sont collés, notamment avec des polymères et/ou des colles époxy et/ou un brasage de verre et/ou brasés et/ou soudés par diffusion.

38. Composant électronique selon l'une des revendications 30 à 37, **caractérisé par le fait qu'**un côté (10) qui est en face de celui (5) des côtés de l'élément semi-conducteur (3) qui comporte le dispositif émetteur et/ou actif sur le plan sensoriel (7) comporte au moins une structure fonctionnelle (11).

39. Composant électronique selon l'une des revendications 30 à 38, **caractérisé par le fait que** le support comporte au moins un passage (17).

40. Composant électronique selon l'une des revendications 30 à 39, **caractérisé par le fait que** le support comporte plusieurs couches (91, 92, 93, 94).

41. Composant électronique selon la revendication 40, **caractérisé par le fait que** les couches (91, 92, 93, 94) comportent chacune au moins une structure fonctionnelle (11) pour le dispositif émetteur et/ou actif sur le plan sensoriel.

42. Composant électronique selon l'une des revendications 30 à 41, **caractérisé par le fait que** le support comporte au moins une cavité, notamment un espace de résonateur.

43. Composant électronique selon l'une des revendications 30 à 42, **caractérisé par le fait que** le support comporte au moins une tranchée, notamment une rainure en V, la tranchée s'étendant de préférence dans une direction le long de la surface du support.
